# EUROPÄISCHE PATENTSCHRIFT

(11) **EP 1 642 323 B1**
(45) Veröffentlichungstag und Bekanntmachung des Hinweises auf die Patenterteilung: **11.01.2012**
(21) Anmeldenummer: 04741551.8
(22) Anmeldetag: 12.05.2004
(51) Int. Cl.: H01L 21/68

(54) **VORRICHTUNG ZUR WAFERINSPEKTION**
WAFER INSPECTION DEVICE
DISPOSITIF DE CONTROLE DE TRANCHES DE SEMI-CONDUCTEUR

(30) Priorität: 05.07.2003 DE 10330506
(43) Veröffentlichungstag der Anmeldung: 05.04.2006
(73) Patentinhaber: Vistec Semiconductor Systems GmbH, 35781 Weilburg (DE)
(72) Erfinder: HALAMA, Michael, 35578 Wetzlar (DE); KREH, Albert, 35606 Solms (DE); SCHMIDT, Guenter, 35638 Leun (DE)
(74) Vertreter: Reichert, Werner Franz
(86) Internationale Anmeldenummer: PCT/EP2004/050765
(87) Internationale Veröffentlichungsnummer: WO 2005/004208

(56) Entgegenhaltungen:
- EP-A- 0 669 643
- EP-A- 1 300 932
- US-A- 3 967 132
- US-A1- 2003 094 059
- PATENT ABSTRACTS OF JAPAN Bd. 013, Nr. 559 (M-905), 12. Dezember 1989 (1989-12-12) -& JP 01 230986 A (EAGLE IND CO LTD), 14. September 1989 (1989-09-14)

## Beschreibung

Die Erfindung betrifft eine Vorrichtung zur Waferinspektion. Insbesondere betrifft die Erfindung eine Vorrichtung zur Detektion von Defekten auf der Oberfläche eines Wafers, der auf einem in zwei senkrecht zueinander stehenden Richtungen, verfahrbaren Tisch angeordnet ist.

In der Halbleiterfertigung werden Wafer während des Fertigungsprozesses in einer Vielzahl von Prozessschritten sequentiell bearbeitet. Mit zunehmender Integrationsdichte steigen die Anforderungen an die Qualität der auf den Wafern ausgebildeten Strukturen. Um die Qualität der ausgebildeten Strukturen überprüfen und eventuelle Defekte finden zu können, ist das Erfordernis an die Qualität, die Genauigkeit und die Reproduzierbarkeit der den Wafer handhabenden Bauteile entsprechend. Dies bedeutet, dass der Tisch, der den Wafer in den zwei senkrecht zueinander angeordneten Richtungen verfährt bei der Positionsbestimmung und bei Wiedererlangung der Position nach einen besonderen Ereignis, wie z. B. Stromausfall, Versagen der Steuersoftware und/öder Nothalt des gesamten Systems, eine schnelle und sichere Einstellung ermöglicht.

Die Europäische Patentanmeldung EP 1 300 932 A2 offenbart einen Linearmotor. Es ist die Problematik angesprochen, dass für eine Kühlung der Spulen des Linearmotors zu sorgen ist. Um dies zu erreichen, sind im Stator und im Träger Leitungen vorgesehen, in denen ein Kühlmittel geführt ist, um somit die durch den Linearmotor erzeugte Wärme abzuführen. Eine Luftlagerung ist nicht angedacht bzw. erwähnt.

Die Europäische Patentanmeldung EP 0 669 643 A1 offenbart eine Wafer-Heizeinrichtung nach einem Stromausfall. Die Wafer-Heizeinrichtung besitzt eine Aufnahme für einen Wafer, in die er während der am Wafer auszuführenden Prozessschritte abgelegt ist. Während normaler Betriebsbedingungen ist der pneumatische Zylinder außerhalb des Wirkungsbereichs des elektrischen Motors, der die Wafer-Heizeinrichtung antreibt. Während eines Stromausfalls wird ein Ventil geöffnet, so dass die Luft den Zylinder betätigt und letztendlich der Wafer aus der Heizeinrichtung herausbewegt wird, bevor diese zu stark abkühlt.

Der Erfindung liegt die Aufgabe eine Vorrichtung zur Waferinspektion zu schaffen mit der die Position des Tisches beim Auftreten eines besonderen Ereignisses sicher fixiert ist.

Diese Aufgabe wird durch eine Vorrichtung mit den Merkmalen des Anspruchs 1 gelöst.

Es ist von besonderen Vorteil, wenn ein in zwei senkrecht zueinander angeordneten Raumrichtungen verfahrbarer Tisch bei auftreten eines besonderen Ereignisses, wie z. B. Stromausfall, Softwareversagen oder Nothalt des gesamten System, an der momentanen Position festgelegt wird, die er gerade einnimmt.

Der verfahrbare Tisch, auf dem ein zu inspizierender Wafer abgelegt ist, ist durch mehrere Luftdüsen luftgelagert. Es ist mindestens ein Ventil vorgesehen, das mit mindestens einer elektrischen Steuereinheit verbunden ist. Das Ventil ist derart ausgestaltet ist, dass an den Luftdüsen Normaldruck vorherrscht, wenn die elektrische Steuereinheit ein entsprechendes Signal liefert oder ein Ereignis anzeigt.

Für die Bewegung des Tisches entlang der beiden senkrecht zueinander angeordneten Richtungen ist jeweils ein erster und ein zweiter elektrischer Antrieb vorgesehen. Der erste und der zweite elektrische Antrieb ist ein Linearmotor.

Der Tisch besteht aus einem ersten und einem zweiten Tischelement. Parallel zum ersten Linearmotor ist mindestens eine erste Schiene angeordnet, die mit einer Vielzahl von Luftdüsen zusammenwirkt, wobei durch die Luftdüsen Luft unter Druck austritt und somit ein Luftlager für die Richtung X bildet. Ebenso ist parallel zum zweiten Linearmotor mindestens eine zweite Schiene angeordnet ist, die mit einer Vielzahl von Luftdüsen zusammenwirkt, wobei durch die Luftdüsen Luft unter Druck austritt und somit ein Luftlager für die Richtung Y bildet. Bei geöffnetem Ventil liegt an den Luftdüsen Normaldruck vor, so dass der Tisch (bzw. das erste und das zweite Tischelement) mit den Luftdüsen auf der ersten und der zweiten Schiene aufsitzt und dadurch in der Position festlegt ist, die der Tisch während der Erzeugung des Signals hatte. Das Ventil kann an der Lüftdüse selbst vorgesehen sein oder direkt in der Luftleitung selbst.

In der Zeichnung ist der Erfindungsgegenstand schematisch dargestellt und wird anhand der Figuren nachfolgend beschrieben. Dabei zeigen:
Fig. 1 eine Draufsicht auf den Tisch gemäß der Erfindung;
Fig. 2 eine Seitenansicht des Tisches parallel zu der X-Richtung;
Fig. 3 eine Seitenansicht des Tisches parallel zu der Y-Richtung;
Fig. 4a eine Detailansicht einer ersten Ausführungsform der Verbindung der Luftdüsen und der Steuereinheit;
Fig. 4b eine Detailansicht einer zweiten Ausführungsform der Verbindung der Luftdüsen und der Steuereinheit; und
Fig.5 eine Darstellung der Anordnung des Tisches im gesamten System zur Inspektion von Wafern.

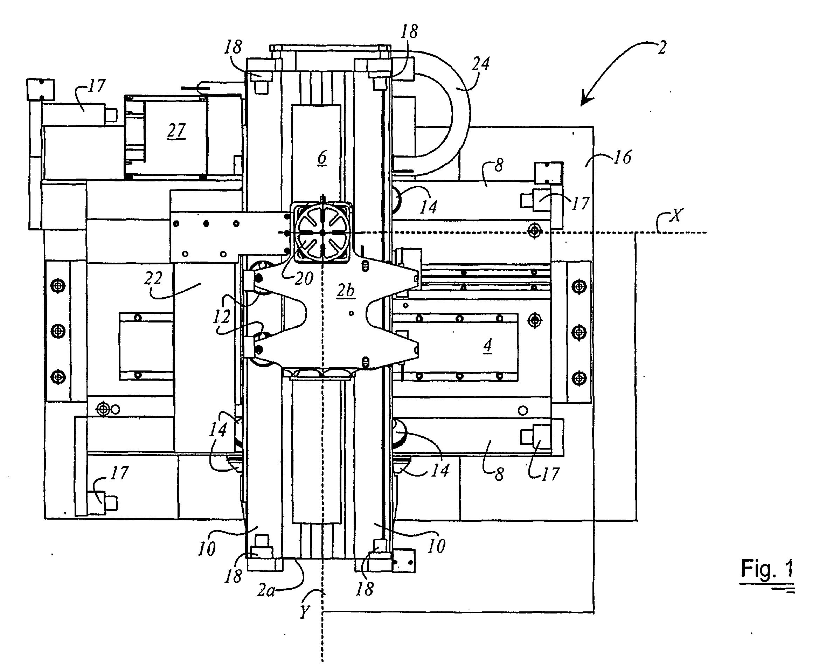

Fig. 1 zeigt eine Draufsicht auf den Tisch 2 der in einer ersten Richtung X und einer zweiten Richtung Y verfahrbar ist. Die erste und die zweite Richtung X, Y sind senkrecht zueinander angeordnet. Für die Bewegung des Tisches 2 entlang der ersten Richtung X ist ein erster elektrischer Antrieb 4 vorgesehen. Für die Bewegung des Tisches 2 entlang der zweiten Richtung Y ist ein zweiter elektrischer Antrieb 6 vorgesehen. Der erste und der zweite elektrische Antrieb 4 und 6 ist jeweils als Linearmotor ausgebildet. Der Tisch 2 ist aus einem ersten Tischelement 2a und einem zweiten Tischelement 2b aufgebaut. Das erste Tischelement 2a ist an mindestens einer Schiene 8 geführt, die parallel zu der ersten Richtung X ist. Ebenso ist das zweite Tischelement 2b ist an mindestens einer weiteren Schiene 10 geführt, die parallel zu der zweiten Richtung Y ist.

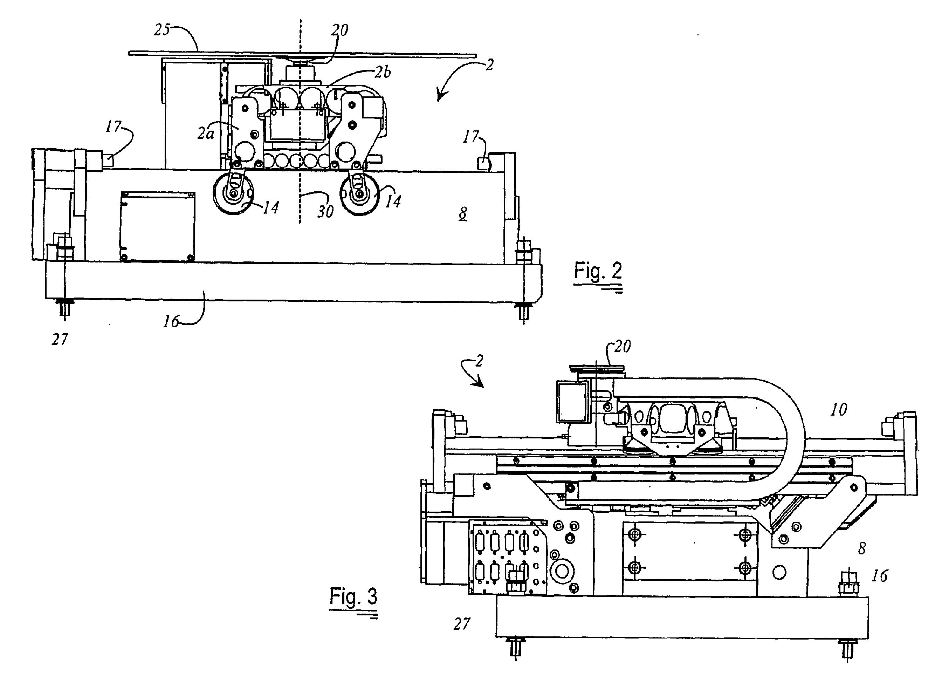

Das zweite Tischelement 2b umfasst mehrere Luftdüsen 12, die mit der mindestens zweiten Schiene 10 zusammenwirken. Ebenso besitzt das erste Tischelement 2b mehrere Luftdüsen 14, die mit der mindestens ersten Schiene 8 zusammenwirken. Durch die Luftdüsen 12 und 14 wird Gas unter einem Druck höher als der vorherrschende Normaldruck ausgeblasen. Somit wird durch die Luftdüsen 12 zwischen den Luftdüsen 12 und der zweiten Schiene 10 ein Luftkissen erzeugt, das das zweite Tischelement 2b auf diesem annähernd reibungsfrei gleiten lässt. Ebenso wird durch die Luftdüsen 14 zwischen den Luftdüsen 14 und der ersten Schiene 8 ein Luftkissen erzeugt, das das erste Tischelement 2a auf diesem annähernd reibungsfrei gleiten lässt. Die mindestens eine erste Schiene 8 und der erste elektrische Antrieb 4 auf einem massiven Block 16 montiert. Hinzu kommt, dass auf dem massiven Block 16 ebenfalls mehrere Anschläge 17 vorgesehen sind, die die Bewegung des ersten Tischelements 2a beidseits in der Richtung X beschränken. Auf dem zweiten Tischelement 2b sind ebenfalls mehrere Anschläge 18 vorgesehen, die die Bewegung des zweiten Tischelements 2b beidseits in der Richtung Y beschränken. Das zweite Tischelement 2b trägt eine Aufnahme 20 für einen Wafer 25 (siehe Fig. 2). In einem flexiblen Band 22 sind mehrere Zuleitungen (nicht dargestellt) zum zweiten Tischelement 2b geführt. In einem weiteren flexiblen Band 24 sind ebenfalls mehrere Zuleitungen (nicht dargestellt) zum ersten Tischelement 2a geführt. Die Zuleitungen zum ersten bzw. zweiten Tischelement 2a oder 2b sind Luftdruckleitungen oder elektrische Leitungen. Mittels der flexiblen Bänder 22 und 24 ist somit ein geordnetes Folgen der Zuleitungen der Bewegungen des ersten und des zweiten Tischelements 2a und 2b möglich.

Fig. 2 zeigt eine Seitenansicht des Tisches 2 parallel zur Richtung X in Fig. 1. Auf der Aufnahme 20 ist ein Wafer 25 aufgelegt und die Aufnahme ist ferner um eine Drehachse 30 drehbar. Das erste Tischelement 2a wirkt mit mehreren Luftdüsen 14 und der mindestens ersten Schiene 8 zusammen. Durch die Luftdüsen 14 wird Gas unter einem Druck höher als der vorherrschende Normaldruck ausgeblasen. Somit wird zwischen den Luftdüsen 14 und der ersten Schiene 8 Luftkissen erzeugt, das das erste Tischelement 2a entlang der ersten Schiene 8 annähernd reibungsfrei gleiten lässt. Die Bewegung des ersten Tischelements 2a wird durch die Anschläge 17 beidseitig beschränkt. Fig. 3 zeigt die Seitenansicht des Tisches 2 parallel zur Richtung Y in Fig. 1. Das zweite Tischelement 2b ist entlang der zweiten Schiene 10 verfahrbar. Die zweite Schiene 10 wirkt mit den mehreren Luftdüsen 12 zusammen, die am zweiten Tischelement 2b vorgesehen sind. Die Luftdüsen 12 erzeugen über das mit Druck austretende Gas ein Luftkissen, auf dem das zweite Tischelement 2b entlang der zweiten Schiene 10 gleitet. Die Bewegung des zweiten Tischelements 2b ist beidseitig durch die Anschläge 18 begrenzt. Der Tisch 2 umfasst ferner eine Steuereinheit 27, mittels der die elektrischen Elemente bzw. die Luftzufuhr zu dem Luftdüsen 12 und 14 des ersten und des zweiten Tischelements gesteuert und geregelt werden. Wie z.B. in Fig. 3 dargestellt ist, ist ein flexibles Band 22 zum zweiten Tischelement 2b geführt.

Im oder am flexiblen Band sind die entsprechenden elektrischen bzw. Luftleitungen von der Steuereinheit 27 zum zweiten Tischelement 2b bzw. zu dessen Luftdüsen 12 vorgesehen.

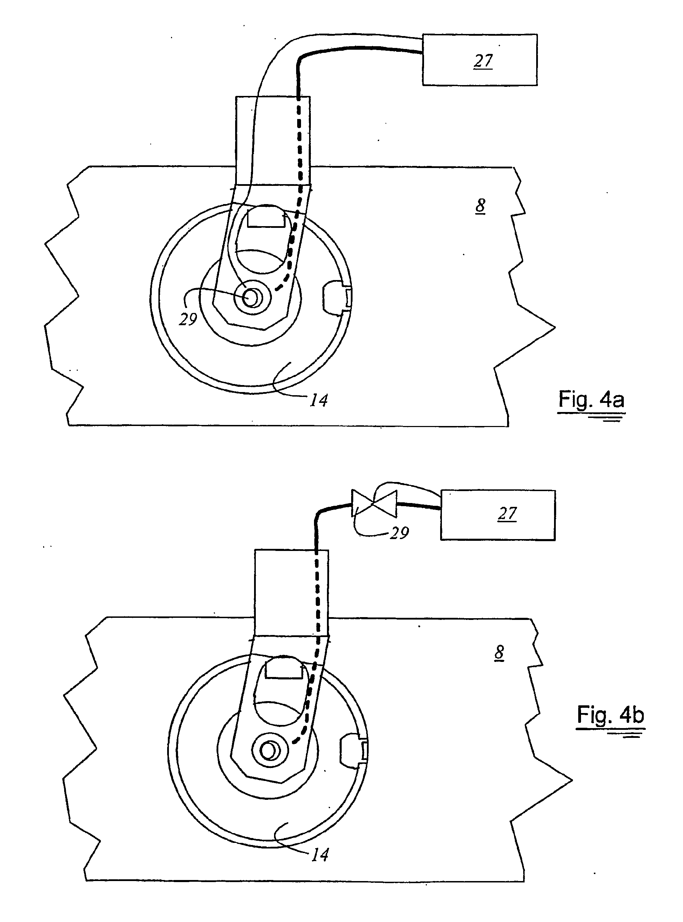

Die Figuren 4a und 4b zeigen eine schematische Darstellung eines Ventils 29 im Wirkzusammenhang mit einer der Luftdüsen 12 oder 14. Das Ventil 29 ist mit der Steuereinheit 27 verbunden, und dass das Ventil derart ausgestaltet ist, dass es in den Luftlagern 12 und 14 Normaldruck herstellt, wenn die elektrische Steuerung 27 ein entsprechendes Signal liefert. Die Steuerung 27 generiert dann ein Signal, wenn z.B. die Software ausfällt, die Stromversorgung des Systems versagt und/oder wenn ein Nothalt des gesamten Systems initialisiert wird. Die Figuren 4a und 4b zeigen jeweils eine Luftdüse12 oder 14, die mit der Schiene 8 zusammenwirkt. Es ist für einen Fachmann selbstverständlich, dass die Auswahl einer Luftdüse für die Darstellung der Erfindung gewählt wurde und für alle anderen Luftdüsen ein entsprechender Wirkzusammenhang gilt. Fig. 4a zeigt ein erstes Ausführungsbeispiel der Erfindung. Das Ventil 29 ist hier direkt an der Luftdüse 14 angeordnet. Die Luftdüse 14 ist über mindestens eine Luftleitung 32 mit der Steuereinheit 27 verbunden. Über die Luftleitung 32 wird die Luftdüse 14 mit Druckluft versorgt. Ebenso ist das Ventil 29 mit der Steuereinheit 27 über eine elektrische Leitung 34 verbunden. Die elektrische Leitung liefert an das Ventil 29 ein entsprechendes Signal, damit das Ventil 29 öffnet und in den Luftlagern Normaldruck herstellt. Durch die Herstellung des Normaldrucks erreicht man, dass aus den Luftdüsen keine Luft austritt und sowohl das erste als auch das zweite Tischelement 2a und 2b auf den jeweiligen Schienen 8 und 10 aufsitzt. In Fig. 4b ist die Ausführungsform dargestellt, dass das Ventil 29 in der Luftleitung 32 von der Steuereinheit 27 zur Luftdüse 14 eingesetzt ist. Das erste und das zweite Tischelement 2a und 2b sind, wie in den Figuren 1 und 2 dargestellt ist, mit flexiblen Bänder 22 und 24 verbunden, die die mindestens eine elektrische Leitung 34 und die mindestens eine Luftleitung 34 von der Steuereinheit zu den Luftdüsen 12 und 14 der Luftlager bzw. zu dem ersten und zweiten Tischelement 2a und 2b führt. Die flexiblen Bänder 22 und 24 üben auf das erste und das zweite Tischelement 2a und 2b eine Kraft aus, die durch die bestromten Linearmotoren leicht überwunden werden kann. Fall z. B. der Strom an den Linearmotoren aus, dann würde die mechanische Kraft der flexiblen Bänder 22 und 24 ausreichen, um das erste und/oder das zweite Tischelement 2a und 2b aus der zu bewegen. Bei der Inspektion von Wafern oder Halbleitersubstraten ist es von besonderer Wichtigkeit, dass die Position des Tisches 2 bzw. des ersten und des zweiten Tischelements 2a und 2b immer bekannt ist. Würde sich der Tisch 2 bei einem Stromausfall oder einem Nothalt ohne Aufzeichnung der Positionsdaten bewegen, dann könnte es beim Neustart des Systems zu Beschädigungen am Wafer kommen, da dieser in die dem System zugeordneten Kassetten (nicht dargestellt) zurücktransportiert werden muss.

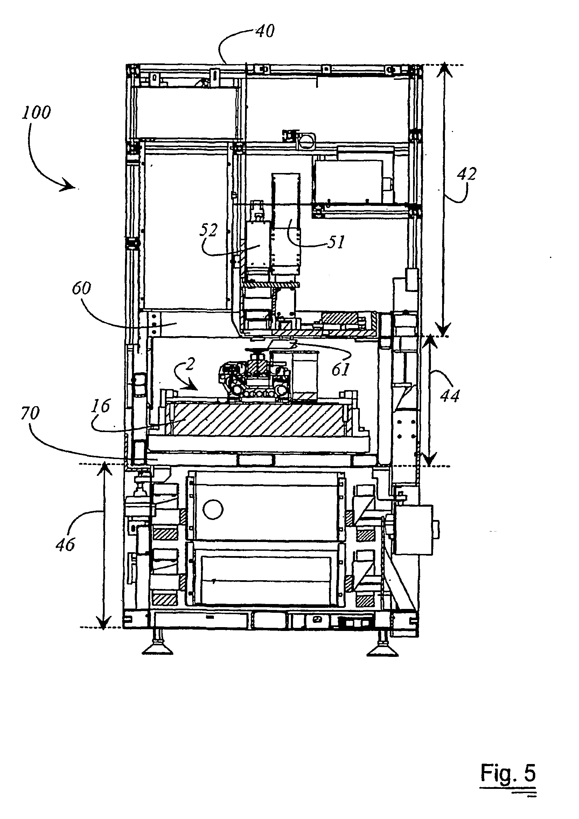

Fig. 5 zeigt eine Darstellung der Anordnung des Tisches 2 im gesamten System 100 zur Inspektion von Wafern. Das System 100 ist von einem Gehäuse 40 umschlossen und ist in einen ersten Abschnitt 42, einen zweiten Abschnitt 44 und einen dritten Abschnitt 46 unterteilt. Das Gehäuse 40 ist an allen Außenflächen mit Wänden (nicht dargestellt) verschlossen, so dass im Innern des Gehäuses 40 bestimmte Reinraumbedingungen vorliegen. Im ersten Abschnitt 42 des Gehäuses 40 sind im Wesentlichen mehrere Beleuchtungseinrichtungen 51 und mindestens eine Detektionseinrichtung 52 untergebracht. Der erste Abschnitt 42 ist vom zweiten Abschnitt 44 durch eine Montageplatte 60 getrennt. Das Licht der Beleuchtungseinrichtungen 51 wird über optische Mittel 61 durch die Montageplatte 60 hindurch auf die Oberfläche des zu inspizierenden Wafers geleitet. Im zweiten Raum ist der Tisch 2 vorgesehen, der, wie bereits in der Beschreibung zu Figur 1 erwähnt ist, in Richtung X und in Richtung Y verfahrbar ist. Der Tisch 2 ist auf einer Trennplatte 70 montiert, die den zweiten und den dritten Abschnitt 44 und 46 voneinander trennt. Der dritte Abschnitt 46 umfasst mehrere Steuereinheiten 27 oder Rechner, die für die Steuerung, Kontrolle und Regelung des Systems 100 und der einzelnen Komponenten des Systems verantwortlich sind. Hinzu kommt, dass hiermit ebenfalls Daten aufgenommen und ausgewertet werden.

## Patentansprüche

1. Vorrichtung (1) zur Waferinspektion, mit einem in zwei senkrecht zueinander angeordneten Richtungen (X, Y) verfahrbaren Tisch (2), auf dem ein zu inspizierender Wafer (25) abgelegt ist und wobei jeweils ein erster und ein zweiter elektrischer Antrieb (4, 6), die als Linearmotore ausgebildet sind, vorgesehen ist; so dass der Tisch (2) entlang der beiden senkrecht zueinander angeordneten Richtungen (X, Y) verfahrbar ist, **dadurch gekennzeichnet, dass** der Tisch (2) mittels mehrerer Luftdüsen (12,14) luftgelagert verfahrbar ist, dass parallel zum ersten Linearmotor mindestens eine erste Schiene (8) angeordnet ist, die mit der Vielzahl von Luftdüsen (12) zusammenwirkt, wobei durch die Luftdüsen (12) Luft unter Druck austritt und somit ein Luftlager für die Richtung (X) bildet und dass parallel zum zweiten Linearmotor mindestens eine zweite Schiene (10) angeordnet ist, die mit der Vielzahl von Luftdüsen (14) zusammenwirkt, wobei durch die Luftdüsen (14) Luft unter Druck austritt und somit ein Luftlager für die Richtung (Y) bildet, dass mindestens ein Ventil (29) vorgesehen ist, das mit mindestens einer elektrischen Steuereinheit (27) verbunden ist, und dass das Ventil (29) derart ausgestaltet ist, dass an den Luftdüsen (12,14) Normaldruck vorherrscht, wenn die elektrische Steuereinheit (27) ein entsprechendes Signal liefert, so dass der Tisch (2) auf der ersten und der zweiten Schiene (8,10) aufsitzt.

2. Vorrichtung (1) nach Anspruch 1, **dadurch gekennzeichnet, dass** das Signal durch einen Spannungsabfall ausgelöst ist.

3. Vorrichtung (1) nach Anspruch 1, **dadurch gekennzeichnet, dass** das Signal durch einen Nothalt ausgelöst ist.

4. Vorrichtung (1) nach Anspruch 1, **dadurch gekennzeichnet, dass** das Signal durch ein Versagen der Software ausgelöst ist.

5. Vorrichtung (1) nach Anspruch 1, **dadurch gekennzeichnet, dass** der Tisch (2) mit den Luftdüsen (12,14) auf der ersten und der zweiten Schiene (8,10) aufsitzt und dass der Tisch (2) in der Position festgelegt ist, die der Tisch (2) während der Erzeugung des Signals hatte.

6. Vorrichtung (1) nach einem der Ansprüche 1 bis 5, **dadurch gekennzeichnet, dass** der Tisch (2) eine Aufnahme (20) für die zu inspizierenden Wafer (25) aufweist.

7. Vorrichtung (1) nach einem der Ansprüche 1 bis 6, **dadurch gekennzeichnet**, das der Tisch (2), die Linearmotoren, die zugehörigen Luftdüsen (12,14) für ein erstes und ein zweites Tischelement (2a, 2b), mindestens eine Steuereinheit (27), Luftleitungen (32) und elektrische Leitungen (34) in einem Gehäuse angeordnet sind.

8. Vorrichtung (1) nach Anspruch 1, **dadurch gekennzeichnet, dass** das Ventil (29) an der Lüftdüse (12,14) selbst vorgesehen ist.

9. Vorrichtung (1) nach Anspruch 1, **dadurch gekennzeichnet, dass** das Ventil (29) in mindestens einer Luftleitung (34) vorgesehen ist.

## Claims

1. A device (1) for wafer inspection, having a table (2), which can be displaced in two directions (X, Y) that are perpendicular to one another, on which the wafer (25) to be inspected is laid and wherein a first and second electrical drive (4, 6) are provided, respectively, which are designed as linear motors; such that the table (2) can be moved along the two directions (X, Y) that are perpendicular to one another, **characterized in that** the table (2) is movable on an air cushion by means of a plurality of air nozzles (12, 14), that at least one first rail (8) is arranged parallel to the first linear motor, the at least one first rail (8) cooperating with the plurality of air nozzles (12), wherein air comes out of the air nozzles (12) under pressure and thus creates an air cushion for the direction (X) and that at least one second rail (10) is arranged parallel to the second linear motor, the at least one second rail (10) cooperating with the plurality of air nozzles (14), wherein air comes out of the air nozzles (14) under pressure and thus creates an air cushion for the direction (Y), that at least one valve (29) is provided, which is connected to at least one electrical control unit (27), and that the valve (29) is designed in such a way that there is a normal pressure present at the air nozzles (12, 14) when the electrical control unit (27) delivers an appropriate signal, so that the table (2) sits on the first and the second rails (8, 10).

2. The device (1) according to Claim 1, **characterized in that** the signal is triggered by a voltage drop.

3. The device (1) according to Claim 1, **characterized in that** the signal is triggered by an emergency stop.

4. The device (1) according to Claim 1, **characterized in that** the signal is triggered by failure of the software.

5. The device (1) according to Claim 1, **characterized in that** the table (2) sits with the air nozzles (12, 14) on the first and second rails (8, 10) and that the table (2) is established in the position at which the table (2) was during generation of the signal.

6. The device (1) according to any one of the claims 1 to 5, **characterized in that** the table (2) has a mount (20) for the wafer (25) to be inspected.

7. The device (1) according to any one of the claims 1 to 6, **characterized in that** the table (2), the linear motors, the associated air nozzles (12, 14) for a first and a second table elements (2a, 2b), at least one control unit (27), air lines (32) and electrical lines (34) are arranged in a housing.

8. The device (1) according to Claim 1, **characterized in that** the valve (29) is provided at the air nozzles (12, 14) itself.

9. The device (1) according to Claim 1, **characterized in that** the valve (29) is provided in at least one air line (34).

## Revendications

1. Dispositif (1) pour l'inspection de plaquettes de silicium, avec une table (2) mobile dans deux directions (X, Y) perpendiculaires l'une par rapport à l'autre, table sur laquelle est posée une plaquette de silicium (25) à inspecter, et étant donné que sont prévus chaque fois un premier et un deuxième systèmes d'entraînement électrique (4, 6) qui sont formés comme moteurs linéaires ; de manière à ce que la table (2) puisse être déplacée le long des deux directions (X, Y) perpendiculaires l'une par rapport à l'autre, **caractérisé en ce que** la table (2) peut être déplacée au moyen d'une pluralité de buses d'air (12, 14) sur coussinet d'air, **en ce qu'**est disposé parallèlement au premier moteur linéaire au moins un premier rail (8) qui coopère avec la pluralité de buses d'air (12), étant donné que de l'air sort sous pression des buses d'air (12) et forme ainsi un coussinet d'air pour la direction (X), et **en ce qu'**est disposé parallèlement au deuxième moteur linéaire au moins un deuxième rail (10) qui coopère avec la pluralité de buses d'air (14), étant donné que de l'air sort sous pression des buses d'air (14) et forme ainsi un coussinet d'air pour la direction (Y), **en ce qu'**est prévu au moins une vanne (29) qui est reliée à au moins une unité de commande électrique (27), et **en ce que** la vanne (29) est conçue de telle sorte qu'une pression normale prévale aux buses d'air (12, 14) lorsque l'unité de commande électrique (27) fournit un signal correspondant, de manière à ce que la table (2) repose sur les premier et deuxième rails (8, 10).

2. Dispositif (1) selon la revendication 1, **caractérisé en ce que** le signal est déclenché par une chute de tension.

3. Dispositif (1) selon la revendication 1, **caractérisé en ce que** le signal est déclenché par un arrêt d'urgence.

4. Dispositif (1) selon la revendication 1, **caractérisé en ce que** le signal est déclenché par une défaillance du logiciel.

5. Dispositif (1) selon la revendication 1, **caractérisé en ce que** la table (2) avec les buses d'air (12, 14) repose sur les premier et deuxième rails (8, 10), et **en ce que** la table (2) est établie à la position qu'avait la table (2) pendant la génération du signal.

6. Dispositif (1) selon l'une quelconque des revendications 1 à 5, **caractérisé en ce que** la table (2) présente un logement (20) pour les plaquettes de silicium (25) à inspecter.

7. Dispositif (1) selon l'une quelconque des revendications 1 à 6, **caractérisé en ce que** la table (2), les moteurs linéaires, les buses d'air (12, 14) correspondantes pour un premier et un deuxième éléments de table (2a, 2b), au moins une unité de commande (27), des conduites d'air (32) et des câbles électriques (34) sont disposés dans un boîtier.

8. Dispositif (1) selon la revendication 1, **caractérisé en ce que** la vanne (29) est prévue à la buse d'air (12, 14) elle-même.

9. Dispositif (1) selon la revendication 1, **caractérisé en ce que** la vanne (29) est prévue dans au moins une conduite d'air (34).
